## Europäisches Patentamt
## European Patent Office
## Office européen des brevets

(11) Veröffentlichungsnummer: **0 133 446**
**B1**

(12) # EUROPÄISCHE PATENTSCHRIFT

(45) Veröffentlichungstag der Patentschrift:
**10.06.87**

(51) Int. Cl.⁴: **G 01 R 7/08**

(21) Anmeldenummer: **84103892.0**

(22) Anmeldetag: **07.04.84**

(54) Kreuzspuldrehmagnetmesswerk.

(30) Priorität: **10.08.83 DE 3328860**

(43) Veröffentlichungstag der Anmeldung:
**27.02.85 Patentblatt 85/9**

(45) Bekanntmachung des Hinweises auf die Patenterteilung:
**10.06.87 Patentblatt 87/24**

(84) Benannte Vertragsstaaten:
**DE FR GB IT NL SE**

(56) Entgegenhaltungen:
**DE-A-3 232 302**
**FR-A-859 293**

(73) Patentinhaber: **VDO Adolf Schindling AG,
Gräfstrasse 103, D-6000 Frankfurt/Main (DE)**

(72) Erfinder: **Lindig, Christian, Rossertstrasse 5a,
D-6233 Kelkheim/Ts. 4 (DE)**
Erfinder: **Duffait, Roland, Bremerstrasse 2-6, D-6236
Eschborn (DE)**

(74) Vertreter: **Könekamp, Herbert, Dipl.- Ing., Sodener
Strasse 9, D-6231 Schwalbach (DE)**

## Beschreibung

Die Erfindung bezieht sich auf ein Kreuzspuldrehmagnetmeßwerk mit einem als Wickelkörper ausgebildeten, annähernd zylindrischen Kern, auf den eine erste und eine zweite Spule übereinander gekreuzt aufgewickelt sind und in dem ein Drehmagnet gelagert ist, dessen Zeigerwelle aus einem Ansatz des Kerns herausgeführt ist, wobei an dem Kern abstandhaltende Mittel angeordnet sind, welche Windungen der Spulen im Abstand zum Ansatz des Kerns um diesen in jeweils einer rechteckigen Ebene führen, und die zweite Spule im Bereich der Stirnseiten des Wickelkörpers über der ersten Spule angeordnet ist und somit eine größere Windungshöhe als diese aufweist.

Derartige bekannte Kreuzspuldrehmagnetmeßwerke werden für verschiedene Meß- und Anzeigezwecke eingesetzt, z. B. zur Füllstand- oder Temperaturmessung, oder aber als Voltmeter oder Amperemeter.

Bekannte Kreuzspuldrehmagnetmeßwerke weisen einen als Wickelkörper verwendeten Kern auf, in dem der Drehmagnet drehbar gelagert ist. Aus einer Stirnseite des im wesentlichen zylindrischen Kerns ragt ein Ansatz heraus, in dem die Drehmagnetwelle untergebracht ist und in die Zeigerwelle übergeht, welche aus dem Ansatz herausgeführt ist. Bei dem Bewickeln des Kerns werden die Windungen der Spulen im Bereich des Ansatzes des Kerns deformiert und liegen so nicht in einer planen rechteckigen Windungsebene. Da außerdem die beiden sich auf dem Kern kreuzenden Spulen im Bereich der Stirnseiten des Kerns zwangsläufig übereinandergewickelt sein müssen, sind die Windungshöhen beider Spulen unterschiedlich. Es hat sich gezeigt, daß mit diesen Kreuzspuldrehmagnetmeßwerken nur Ausschlagwinkel realisiert werden können, die wenig über 90° liegen. Wenn bei diesen Meßwerken im wesentlichen nur der erste Quadrant ausgenutzt wird, kann durch Einstellung wenigstens eines Spannungssignals, mit dem eine der beiden Spulen beaufschlagt wird, eine Eichung auf den gewünschten Endwert des vollen Ausschlags erfolgen. Es ist jedoch nicht ohne weiteres möglich, diese Kreuzspuldrehmagnetmeßwerke zur Anzeige über mehrere Quadranten zu verwenden, da eine Verschiebung des Endwerts im ersten Quadranten zwangsläufig eine entgegengesetzte Verschiebung im dritten Quadranten zur Folge hat.

Es sind des weiteren Kreuzspuldrehmagnetmeßwerke der eingangs genannten Gattung bekannt (FR-A-859 293), mit denen sich Ausschlagwinkel bis zu 180° realisieren lassen, was auf die besondere Anordnung der Spulen durch abstandshaltende Mittel am Kern zurückzuführen ist. Auch diese Kreuzspuldrehmagnetmeßwerke lassen sich jedoch nicht über den zweiten Quadranten hinaus verwenden. Auch läßt die Genauigkeit in den beiden Quadranten noch zu wünschen übrig.

Zu der vorliegenden Erfindung gehört daher die Aufgabe, ein Kreuzspuldrehmagnetmeßwerk der eingangs genannten Gattung so weiterzubilden, daß dieses zur Anzeige über mehrere Quadranten, insbesondere bis zum dritten Quadranten mit genügender Genauigkeit verwendet werden kann. Schwierigkeiten durch eine Eichung mittels Einstellung eines Spannungssignals in einer Spule sollen dabei vermieden werden.

Diese Aufgabe wird erfindungsgemäß dadurch gelöst, daß der Kern im Wickelbereich der ersten Spule einen in dem Maße vergrößerten Durchmesser gegenüber demjenigen eines Wickelbereichs der zweiten Spule aufweist, daß die mittleren Windungslängen der ersten und der zweiten Spule gleich sind.

Durch diese Maßnahme wird in Verbindung mit der Windungsführung ein Linearitätsfehler des Zeigerausschlags über mehrere Quadranten wesentlich herabgesetzt, so daß eine Spannungssteuerung beider Spulen mit zwei Spannungssignalen möglich ist, deren Größtwerte gleich sind. Dadurch wird vermieden, daß durch eine Eichung im ersten Quadranten der Fehler im dritten Quadranten vergrößert wird oder umgekehrt analog.

Die abstandhaltenden Mittel sind vorzugsweise als längliche Stege ausgebildet, die im zylindrischen Wandbereich des Kerns eingelassen sind und die wenigstens so breit wie der Ansatz des Kerns sind, wo die Zeigerwelle herausgeführt wird. Mit den länglichen Stegen, die vorzugsweise in die Stirnseiten des Kerns hineinragen und an den Stirnseiten sowie über ihre Oberseiten abgerundet sind, wird eine besonders zuverlässige den Wickelvorgang nicht störende Führung des Wickeldrahts gewährleistet.

Eine Ausführungsform des erfindungsgemäßen Wickelkorpers wird im folgenden anhand einer Zeichnung mit zwei Figuren beschrieben. In der Zeichnung sind dargestellt:

Fig. 1 der Kern in einer Draufsicht auf die Seite, aus der der - nicht dargestellte - Ansatz herausragt und

Fig. 2 der Kern in einer Seitenansicht.

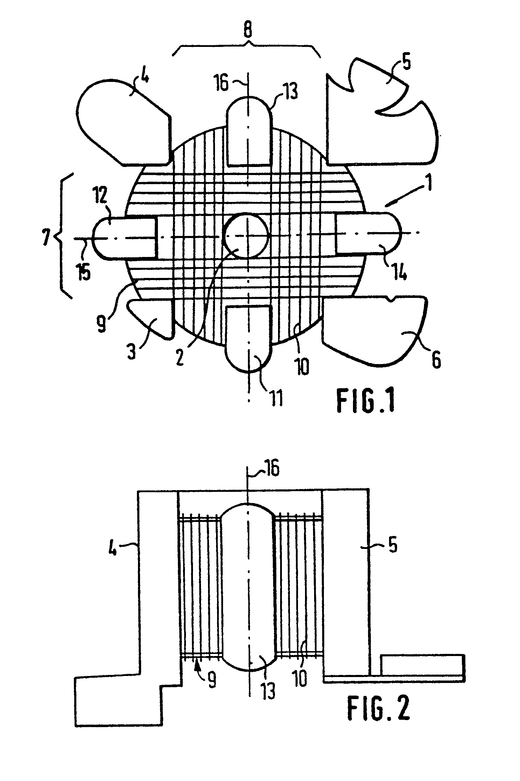

Aus Fig. 1 und 2 ist die im wesentlichen zylindrische Form des als Wickelkörper verwendeten Kerns, der allgemein mit 1 bezeichnet ist, ersichtlich. Ein nicht dargestellter Ansatz für eine ebenfalls nicht dargestellte Zeigerwelle ragt aus der Stelle 2 aus einer Stirnseite des Kerns heraus. Durch Führungselemente 3 bis 6 an der Peripherie der Zylinderform des Kerns wird dieser in zwei Wickelbereiche 7 und 8 unterteilt. Der Wickelbereich ist zum Bewickeln des Kerns mit einer ersten Spule 9 vorgesehen, über die in dem zweiten Wickelbereich eine zweite Spule 10 um 90° gekreuzt gewickelt wird.

Wie in Fig. 1 angedeutet, ist der Kerndurchmesser im Wickelbereich 7 größer als im Wickelbereich 8, und zwar so, daß die größere Windungshöhe der zweiten Spule 10 gegenüber der ersten Spule 9 ausgeglichen wird, d.h. daß die mittlere Windungslänge für beide Spulen 9 und 10 gleich ist. Daraus ergeben sich weiter für gleiche Signalspannungen in beiden Spulen, eine gleiche Windungszahl und bei gleichem Drahtdurchmesser ein gleicher Widerstand beider Spulen.

Im Zusammenhang mit den voranstehenden Maßnahmen ist außerdem die konstruktive Maßnahme zu sehen, daß durch vier längliche Stege 11 bis 14 dafür gesorgt wird, daß die Windungen der Spulen nicht aus dem Bereich des Ansatzes an der Stelle 2 weggedrückt werden, sondern in planen rechteckigen Ebenen geführt sind. Die planen rechteckigen Ebenen schneiden gedanklich den Kern in Längsebenen außerhalb dessen gedachter zentraler Längsachse. Die länglichen Stege unterteilen jeden, der beiden Wickelbereiche 7 und 8 in zwei gleich große Wickelteilbereiche. Es liegen also zur Bewicklung des Kerns um zwei Ebenen symmetrische Verhältnisse vor, und zwar zu den gedachten Mittelebenen, die einerseits durch die Stege 11 und 13 und andererseits durch die Stege 12 und 14 verlaufen. Diese Mittelebenen sind mit 15 und 16 bezeichnet.

Die an den Stirnseiten und auf ihren äußeren Oberflächen abgerundete Form der Stege 11 bis 14 ergibt sich im einzelnen aus der Zeichnung. Diese Formgebung kann den Wickelvorgang erleichtern und eine Beschädigung des Drahts zusätzlich vermeiden helfen.

Es hat sich überraschenderweise gezeigt, daß bei einem Kreuzspuldrehmagnetmeßwerk der beschriebenen Art die Linearität beispielsweise um 500 % verbessert werden kann.

## Patentansprüche

1. Kreuzspuldrehmagnetmeßwerk mit einem als Wickelkörper ausgebildeten, annähernd zylindrischen Kern (1), auf den eine erste (9) und eine zweite Spule (10) übereinander gekreuzt aufgewickelt sind und in dem ein Drehmagnet gelagert ist, dessen Zeigerwelle aus einem Ansatz des Kerns (1) herausgeführt ist, wobei an dem Kern (1) abstandshaltende Mittel (Stege 11-14) angeordnet sind, welche Windungen der Spulen (9, 10) im Abstand zum Ansatz des Kerns (1) um diesen in jeweilseiner rechteckigen Ebene führen, und die zweite Spule (10) im Bereich der Stirnseiten des Wickelkörpers über der ersten Spule (9) angeordnet ist und somit eine größere Windungshöhe als diese aufweist, dadurch gekennzeichnet, daß der Kern (1) im Wickelbereich (7) der ersten Spule (9) einen in dem Maße vergrößerten Durchmesser gegenüber demjenigen eines Wickelbereichs (8) der zweiten Spule (10) aufweist, daß die mittleren Windungslängen der ersten und der zweiten Spule gleich sind.

2. Kreuzspuldrehmagnetmeßwerk nach Anspruch 1, dadurch gekennzeichnet, daß als abstandshaltende Mittel längliche Stege (11-14) in die zylindrischen Wandbereiche des Kerns eingelassen sind, die wenigstens so breit wie der Ansatz (Stelle 2) des Kerns ist.

## Claims

1. Crossed-coil rotary-magnet measuring system having an approximately cylindrical core (1) which is constructed as the winding support and on to which a first (9) and a second coil (10) are wound crossed over one another, and in which there is mounted a rotary magnet, the pointer shaft of the said magnet extending out of a nose of the core (1), there being arranged on the core (1) spacing means (ridges 11 - 14) whereby turns of the coils (9, 10) are guided each in a rectangular plane about the core (1) with spacing from the nose of the core, the second coil (10) being arranged over the first coil (9) in the region of the end faces of the winding support and thus having a greater turn height than the latter coil, characterised in that in the winding region (7) of the first coil (9) the core (1) has a diameter which is larger than that of the winding region (8) of the second coil (10) to the extent that the mean turn lengths of the first and second coils are equal.

2. Crossed-coil rotary-magnet measuring system according to claim 1, characterised in that, as spacing means, elongated ridges (11 -14) are embedded into the cylindrical wall regions of the core and are at least as wide as the nose (region 2)

## Revendications

1. Système de mesure à aimant mobile à enroulements croisés, comportant un noyau (1) sensiblement cylindrique qui constitue un corps de bobine, sur lequel des premier (9) et second (10) enroulements sont bobinés en croix l'un sur l'autre et dans lequel est monté un aimant mobile dont l'axe porte-aiguille fait saillie d'un prolongement de ce noyau (1), des éléments d'entretoisement (barrettes 11-14) disposés sur ce dernier guidant les spires des enroulements (9, 10) autour dudit noyau en les maintenant à une certaine distance de ce prolongement et en leur faisant former des rectangles parfaitement plans, le second enroulement (10) étant disposé au-dessus du premier (9) sur les surfaces d'extrémité du noyau et ses spires ayant donc une hauteur plus grande que celles de ce premier enroulement, système caractérisé en ce que, dans la zone de bobinage (7) du premier enroulement (9), le diamètre du noyau (1) est agrandi par rapport à celui de la zone de bobinage (8) du second enroulement (10) dans la proportion voulue pour que les longueurs moyennes des spires de ces premier et second enroulement soient les mêmes.

2. Système de mesure selon la revendication 1, caractérisé en ce que les éléments d'entretoisement sont des barrettes oblongues (11-14), qui sont encastrées dans la paroi cylindrique du noyau et qui sont au moins aussi larges que le prolongement (emplacement 2) de ce noyau.

FIG.1

FIG.2